# EUROPEAN PATENT APPLICATION

(11) **EP 3 007 525 A1**
(43) Date of publication of application: **13.04.2016**
(21) Application number: 14187876.9
(22) Date of filing: 07.10.2014
(51) Int. Cl.: H05K 3/00, H05K 3/12

(54) **Method of printing conductive metal circuit diagram on circuit substrate by lithography and printed product thereof**

(71) Applicant: Bai Sha Technology Corp., Taiching 41180 (TW)
(72) Inventor: Lin, Yen-Shu, 40756 Xitun Dist., Taichung (TW)
(74) Representative: 2K Patentanwälte Blasberg Kewitz & Reichel

(57) **Abstract**

A method of printing a conductive metal circuit diagram on a circuit substrate (40) by lithography and a printed product thereof, characterized in that a multi-color automatic printing machine (10) and a plurality of printing stencils (32, 34, 36) are provided for printing a desired product, wherein a first printing ink holder (11) of the multi-color automatic printing machine is filled with an adhesive, and a second printing ink holder (12) is modified into a cooling bronzing device and installed with a roller type conductive metal foil material, and then each printing ink holder (13-15) is filled with different color printing inks according to printing requirements, and the adhesive ink holder (11) and a stencil holder (111-151) of each coloring ink holder is equipped with a corresponding printing stencil, and each printing stencil is etched with a pattern desired for printing a circuit, a mark, a symbol, or a text, and after the circuit substrate (40) is conveyed according to an automatic conveying route of the multi-color automatic printing machine, a conductive metal circuit diagram (42) and related printing and coloring processes are completed quickly.

## Description

### BACKGROUND OF THE INVENTION

### (a) Field of the Invention

The present invention relates to a method of printing a conductive metal circuit diagram on a circuit substrate by lithography and a printed product manufactured by the method, and more particularly to the printing method and printed product capable of quickly printing a conductive metal circuit diagram required by a circuit substrate and achieving the related printing purpose by using advanced printing machineries, innovative printing procedures and a synchronous operation method, so as to improve the manufacturing efficiency and save the total manufacturing cost.

### (b) Description of the Related Art

A "printed circuit board" is a basic unit of an electronic device, and the printed circuit board includes a metal circuit diagram printed thereon for electrically connecting an electronic circuit, and the position of a circuit or the position of a mark is reserved, and various electronic components, microprocessors or other electronic accessories are installed and connected, and thus the printed circuit acts as a basic core of the electronic device. It is noteworthy that the subject of the present invention focuses on the initial manufacturing process of printing a metal circuit diagram onto a circuit substrate.

At present, a screen printing process is used extensively, wherein a conductive metal layer is attached onto a circuit substrate first, and then an anti-corrosive protecting material is printed onto the conductive metal layer by screen printing, and the extra metal layer other than the pattern of the circuit is removed by etching, photosensitive technique or laser engraving, and then the anti-corrosive protecting material is removed, so as to obtain a "semi-finished product" of the printed circuit board only having the metal circuit diagram remained.

The reason for calling the printed circuit board having the metal circuit diagram as a semi-finished product is because important printing procedures of printing a plurality of other required marks, symbols or texts on the end surface of the printed circuit board is required to facilitate a smooth operation that follows. The basic manufacturing procedures including the steps of adhering the metal layer, coating the anti-corrosive protecting material, etching, rinsing, printing and re-rinsing (to remove extra ink), etc are very complicated, time-consuming and noncompliant to cost effectiveness and environmental protection requirements, not even mentioning how complicated are the following operations of the finished good of the printed circuit board. Obviously, the prior art requires improvements.

### SUMMARY OF THE INVENTION

Therefore, it is a primary objective of the present invention to print a predetermined conductive metal circuit diagram, marks, symbols, and/or texts by a single lithographic procedure and provide an overall printing procedure for coloring different areas of the conductive metal circuit diagram to achieve the effect of improving the manufacturing efficiency and saving the printing time and cost significantly.

According to the invention, a method of printing a conductive metal circuit diagram on a circuit substrate by lithography and a printed product thereof, characterized in that a multi-color automatic printing machine and a plurality of printing stencils are provided for printing a desired product, wherein a first printing ink holder of the multi-color automatic printing machine is filled with an adhesive, and a second printing ink holder is modified into a cooling bronzing device and installed with a roller type conductive metal foil material, and then each printing ink holder is filled with different color printing inks according to printing requirements, and the adhesive ink holder and a stencil holder of each coloring ink holder is equipped with a corresponding printing stencil, and each printing stencil is etched with a pattern desired for printing a circuit, a mark, a symbol, or a text, and after the circuit substrate is conveyed according to an automatic conveying route of the multi-color automatic printing machine, a conductive metal circuit diagram and related printing and coloring processes are completed quickly.

### BRIEF DESCRIPTION OF THE FIGURES

Fig. 1 is a schematic view of a modified multi-color automatic printing machine in accordance with the present invention;
Fig. 2 is a schematic view of a printing procedure in accordance with a preferred embodiment of the present invention;
Fig. 3 is a schematic view of a circuit printing stencil in accordance with a preferred embodiment of the present invention;
Fig. 4 is a schematic view of a color printing stencil in accordance with a preferred embodiment of the present invention;
Fig. 5 is a schematic view of another color printing stencil in accordance with a preferred embodiment of the present invention;
Fig. 6 is a schematic view of a further color printing stencil in accordance with a preferred embodiment of the present invention;
Fig. 7 is a partial cross-sectional view of a preferred embodiment of a printed circuit board manufactured by the manufacturing procedure of the present invention; and
Fig. 8 is a schematic view of another modified multi-color automatic printing machine in accordance with the present invention.

### DETAILED DESCRIPTION OF THE PREFERRED EMBODIMENT

The technical measures and characteristics of the present invention will become clearer in light of the following detailed description of an illustrative embodiment of this invention described in connection with the drawings.

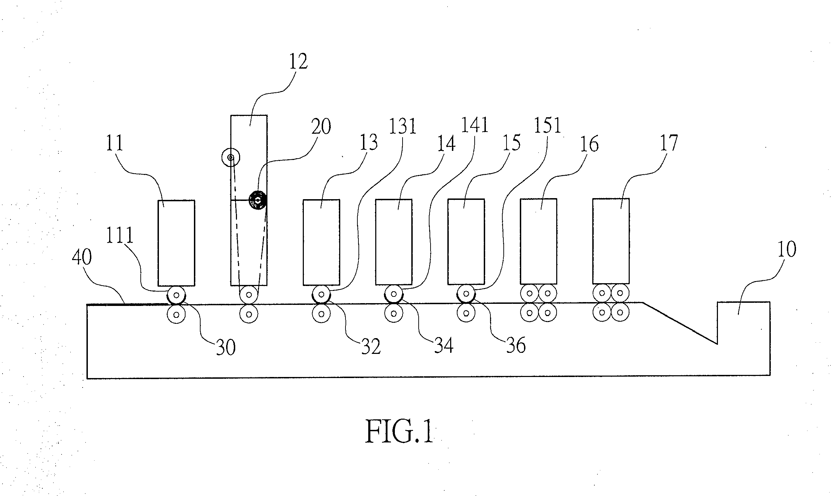

With reference to Fig. 1 for a modified multi-color automatic printing machine 10 in accordance with the present invention, the first component is an adhesive ink holder 11 filled with an adhesive, and the second component is a bronzing ink holder 12 installed with a roller type conductive metal foil material 20, and then each coloring ink holder 13, 14, 15 is filled with different color printing inks according to the printing requirements, and the adhesive ink holder 11 and each stencil holder 111, 131, 141, 151 of the coloring ink holder 13, 14, 15 has a corresponding circuit printing stencil 30 and a corresponding color printing stencil 32, 34, 36 respectively, and desired printing circuit etched-lines 31 and pattern etched-lines 33, 35, 37 such as circuits, marks, symbols, and texts are printed on each circuit printing stencil 30 and each color printing stencil 32, so that after the circuit substrate 40 is sent according to an automatic conveying route of the multi-color automatic printing machine 10, the conductive metal circuit diagram and related printing and coloring processes are completed quickly.

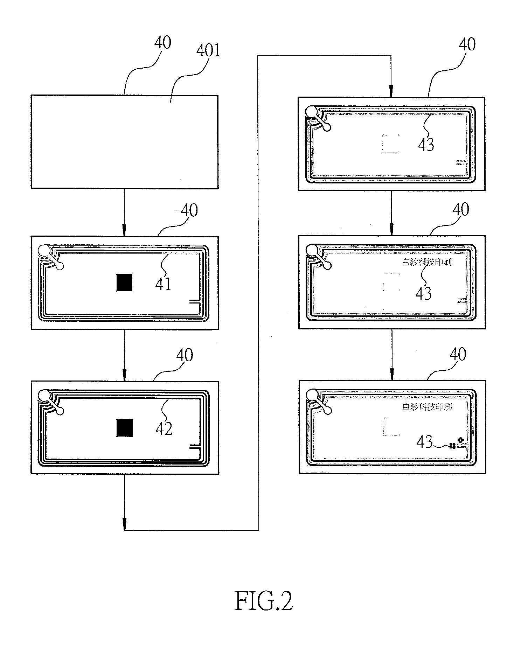

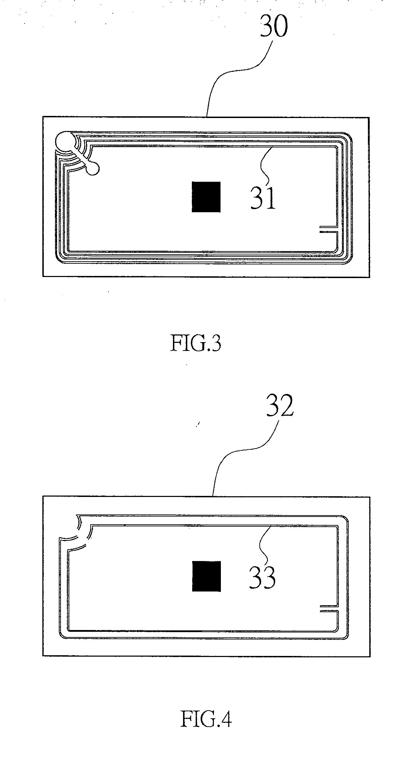

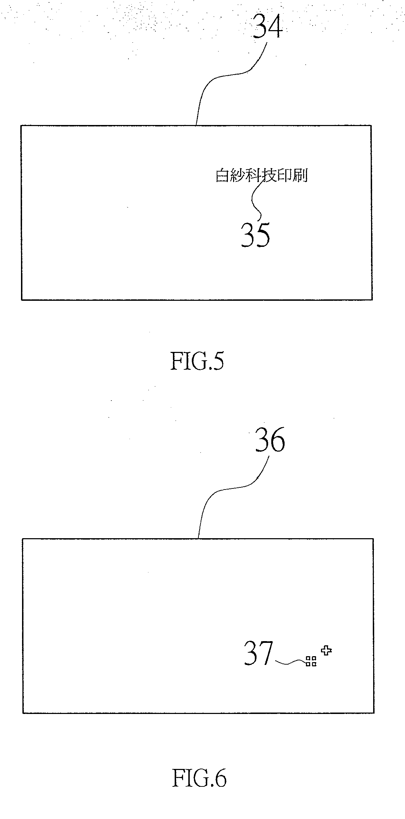

With reference to FIG. 2 for a preferred embodiment of a printing procedure of the present invention, FIG. 3 for a preferred embodiment of a circuit printing stencil of the present invention, and FIGS. 4 to 6 for preferred embodiments of different color printing stencils of the present invention respectively, the printing procedure comprises the following steps:
Firstly, when a circuit substrate 40 enters into an adhesive ink holder 11 of a multi-color automatic printing machine 10, the circuit substrate 40 is coated with an adhesive layer 41 which is the same as the circuit etched-line 31 formed on a corresponding circuit printing stencil 30, and then the circuit substrate 40 is entered into bronzing ink holder 12, so that the adhesive layer 41 disposed on the conductive metal foil material 20 is provided for attaching and carrying a conductive metal with an adhesive force of the adhesive layer 41 to form a conductive metal circuit diagram 42. The circuit substrate 40 is entered into various different coloring ink holders 13, 14, 15 to form a coloring layer 43 according to an etched-line 33, 35, 37 of the corresponding color printing stencil 32, 34, 36 so as to print various desired marks (indicated by blue color in the figure), symbols, texts (indicated by red color in the figure) and colors.

The main reason to apply the conductive metal circuit diagram 42 at some places, specific areas or specific lines for coloring and color treatment (indicated by gold color in the figure) resides on that after the product is conveyed to a backend for use (such as a backend process including a boring process, a welding process, a cutting process, a packaging process, etc), the backend operator can determine and label a manufacturing position easily by clear color indications. Such arrangement not just expedites the operation efficiency only, but also achieves the effect of preventing an incorrect manufacture.

The circuit substrate 40 is an insulating board such as an electric bakelite board, a fiberglass board or a plastic substrate extensively used in various hard and flexible printed circuits.

In addition, plural spare ink holders 16, 17 are reserved after the last coloring ink holder 15 and provided for the spare use whenever more printing is required.

To increase the thickness of the metal coating of the conductive metal circuit diagram 42 in order to comply with the required conduction requirement and conduction coefficient, the gluing and bronzing processes are repeated on the same printing side. Similarly, the double-sided printing process may be applied to the circuit substrate 40. However, this method is a simple alternative method, and thus will not be described in details.

In summation, the present invention uses the multi-color automatic printing machine 10 and appropriate additions and modifications, fully applies the present existing printing equipments to improve the industrial application and performance, and further reducing the printing time and cost for the manufacture of the printed circuit board.

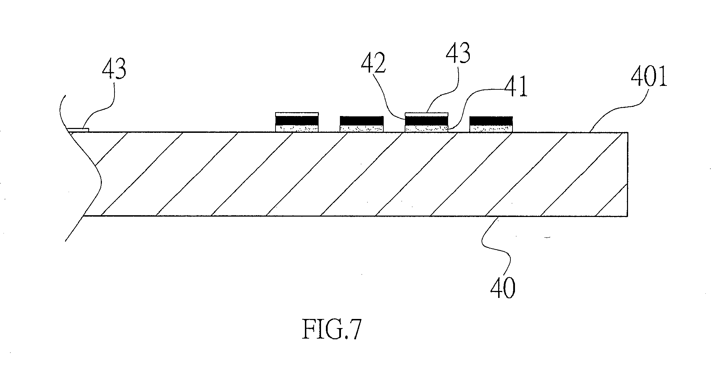

In Fig. 7, the printed product manufactured by the method of the present invention comprises:
a circuit substrate 40, which is an insulating board including an electric bakelite board, a fiberglass board or a plastic substrate and applied in various types of hard and flexible printed circuits;
an adhesive layer 41, coated on a printing end surface 401 of the circuit substrate 40, wherein the range of coating covers a pattern of the conductive metal circuit diagram 42;
a conductive metal circuit diagram 42, made of a conductive metal, and adhered on the adhesive layer 41; and
a coloring layer 43, having different colors printed on the printing end surface 401 of the circuit substrate 40 or the conductive metal circuit diagram 42 to form various types of marks, symbols, texts, specific partial blocks or specific lines.

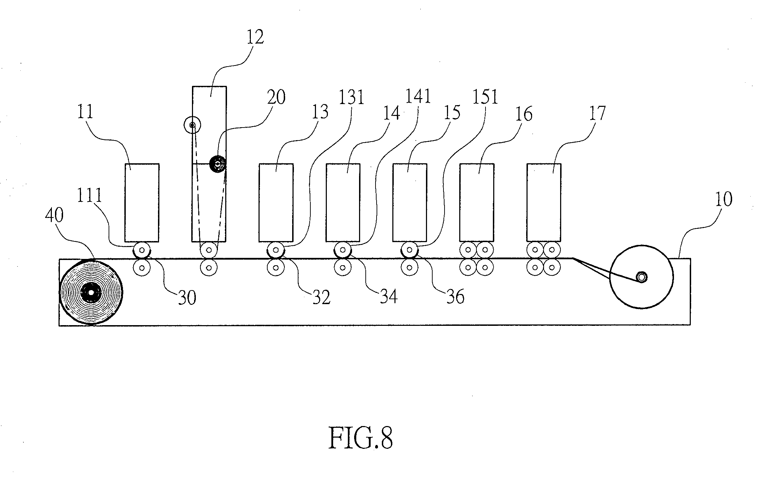

With reference to Fig. 8 for another modified multi-color automatic printing machine 10 in accordance with the present invention, a rolling feed mechanism and a winding feed mechanism are provided to cope with different types (including page and roll) of the circuit substrate 40 without changing other steps of the original printing procedure, so as to improve the general applicability.

It is noteworthy that the multi-color automatic printing machine 10 mentioned herein refers to the conventional printing machine, and the operating mode and procedure are prior arts and not intended to be claimed in the present invention, and thus it will not be described in details.

In summary, there are disclosed method of printing a conductive metal circuit diagram on a circuit substrate 40 by lithography and a printed product thereof, characterized in that a multi-color automatic printing machine 10 and a plurality of printing stencils 32, 34, 36 are provided for printing a desired product, wherein a first printing ink holder 11 of the multi-color automatic printing machine is filled with an adhesive, and a second printing ink holder 12 is modified into a cooling bronzing device and installed with a roller type conductive metal foil material, and then each printing ink holder 13-15 is filled with different color printing inks according to printing requirements, and the adhesive ink holder 11 and a stencil holder 111-151 of each coloring ink holder is equipped with a corresponding printing stencil, and each printing stencil is etched with a pattern desired for printing a circuit, a mark, a symbol, or a text, and after the circuit substrate 40 is conveyed according to an automatic conveying route of the multi-color automatic printing machine, a conductive metal circuit diagram 42 and related printing and coloring processes are completed quickly.

Many changes and modifications in the above-described embodiments of the invention can, of course, be carried out without departing from the scope thereof. Accordingly, to promote the progress in science and the useful arts, the invention is disclosed and is intended to be limited only by the scope of the appended claims.

## Claims

1. A method of printing a conductive metal circuit diagram on a circuit substrate (40) by lithography and a printed product thereof, **characterized in that** a multi-color automatic printing machine (10) and a plurality of printing stencils (32, 34, 36) are provided for printing a desired product, wherein a first printing ink holder (11) of the multi-color automatic printing machine is filled with an adhesive, and a second printing ink holder (12) is modified into a cooling bronzing device and installed with a roller type conductive metal foil material (20), and then each printing ink holder (13-15) is filled with different color printing inks according to printing requirements, and the adhesive ink holder (11) and a stencil holder (111-151) of each coloring ink holder is equipped with a corresponding printing stencil, and each printing stencil is etched with a pattern desired for printing a circuit, a mark, a symbol, or a text, and after the circuit substrate (40) is conveyed according to an automatic conveying route of the multi-color automatic printing machine, a conductive metal circuit diagram (42) and related printing and coloring processes are completed quickly.

2. The method of printing a conductive metal circuit diagram on a circuit substrate by lithography and a printed product thereof as claimed in claim 1, wherein the multi-color automatic printing machine (10) reserves a spare ink holder (16, 17).

3. A method of printing a conductive metal circuit diagram on a circuit substrate (40) by lithography and a printed product thereof, **characterized in that** a multi-color automatic printing machine (10) and a plurality of printing stencils (32, 34, 36) are provided for printing a desired product, wherein a first printing ink holder (11) of the multi-color automatic printing machine is filled with an adhesive, and a second printing ink holder (12) is modified into a cooling bronzing device and installed with a roller type conductive metal foil material (20), and then each printing ink holder is filled with different color printing inks according to printing requirements, and the adhesive ink holder (11) and a stencil holder (111-151) of each coloring ink holder is equipped with a corresponding printing stencil, and each printing stencil is etched with a pattern desired for printing a circuit, a mark, a symbol, or a text, and after the circuit substrate is conveyed according to an automatic conveying route of the multi-color automatic printing machine (10), a conductive metal circuit diagram (42) and related printing and coloring processes are completed quickly, and the printed product comprises:
a circuit substrate (40), which is an insulating board including an electric bakelite board, a fiberglass board or a plastic substrate and applied in various types of hard and flexible printed circuits;
an adhesive layer (41), coated on a printing end surface of the circuit substrate, wherein the range of coating covers a pattern of the conductive metal circuit diagram;
a conductive metal circuit diagram (42), made of a conductive metal, and adhered on the adhesive layer; and
a coloring layer (43), having different colors printed on the printing end surface of the circuit substrate or the conductive metal circuit diagram to form various types of marks, symbols, texts, specific partial blocks or specific lines.

4. The method of printing a conductive metal circuit diagram on a circuit substrate (40) by lithography and a printed product thereof as claimed in claim 3, wherein the circuit substrate is printed on both sides.

5. A printed product being manufactured by the method of claim 1 or 3, the printed product comprising:
a circuit substrate (40), which is an insulating board including an electric bakelite board, a fiberglass board or a plastic substrate and applied in various types of hard and flexible printed circuits;
an adhesive layer (41), coated on a printing end surface of the circuit substrate, wherein the range of coating covers a pattern of the conductive metal circuit diagram;
a conductive metal circuit diagram (42), made of a conductive metal, and adhered on the adhesive layer; and
a coloring layer (43), having different colors printed on the printing end surface of the circuit substrate or the conductive metal circuit diagram to form various types of marks, symbols, texts, specific partial blocks or specific lines.
